(19) Europäisches Patentamt / European Patent Office / Office européen des brevets

(11) **EP 2 276 173 B1**

(12) **FASCICULE DE BREVET EUROPEEN**

(45) Date de publication et mention de la délivrance du brevet:
**26.02.2014 Bulletin 2014/09**

(51) Int Cl.:
***H03K 17/16*** *(2006.01)*     *H03K 17/0812* *(2006.01)*

(21) Numéro de dépôt: **10165936.5**

(22) Date de dépôt: **15.06.2010**

(54) **Dispositif de commande d'un transistor de puissance**

Treiber für einen Leistungstransistor

Driver for a power transistor

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **07.07.2009 FR 0954681**

(43) Date de publication de la demande:
**19.01.2011 Bulletin 2011/03**

(73) Titulaire: **Schneider Toshiba Inverter Europe SAS
27120 Pacy sur Eure (FR)**

(72) Inventeur: **Grbovic, Petar
27120 Pacy sur Eure (FR)**

(74) Mandataire: **Bié, Nicolas et al
Schneider Electric Industries SAS
Service Propriété Industrielle
35 rue Joseph Monier - CS 30323
92506 Rueil-Malmaison Cedex (FR)**

(56) Documents cités:
**US-B1- 6 445 557**

- **GRBOVIC ET AL: "An IGBT Gate Driver for Feed-Forward Control of Turn-on Losses and Reverse Recovery Current", IEEE TRANSACTIONS ON POWER ELECTRONICS,, vol. 23, no. 2, 1 mars 2008 (2008-03-01), pages 643-652, XP002559612,**

**EP 2 276 173 B1**

**Description**

La présente invention se rapporte à un dispositif de commande d'un transistor de puissance, plus particulièrement d'un transistor à effet de champ à jonction de type JFET (Junction Field Effect Transistor). Le transistor JFET sera par exemple réalisé dans un matériau à grande énergie de bande interdite tel que le carbure de silicium ou le nitrure de gallium. Ce type de transistor peut notamment être employé dans un onduleur à modulation de largeur d'impulsion (MLI ou PWM pour Pulse Width Modulation en anglais).

De nombreuses publications ont été rédigées au sujet de la commande de transistors, notamment de type IGBT (Insulated Gate Bipolar Transistor).

Dans la commande d'un transistor, le problème principal à résoudre est de pouvoir contrôler la vitesse de commutation du transistor. Pour cela, il faut pouvoir contrôler indépendamment l'une de l'autre la variation du courant en fonction du temps (di/dt) et la variation de la tension en fonction du temps (dV/dt). Lors de la mise en conduction du transistor, le but est par exemple de réduire le di/dt et d'augmenter le dV/dt. Cependant, la plupart du temps, les commandes connues ne sont pas satisfaisantes.

La publication intitulée "An IGBT Gate Driver for Feed-Forward control Turnon Losses and Reverse Recovery Current" de Petar J. Grbovic - IEEE Transactions on Power Electronics, vol 23, N°2, March 2008, page 643 décrit un dispositif de commande satisfaisant pour un transistor de type IGBT. Ce type de dispositif permet notamment de limiter les pertes lors de la mise en conduction du transistor. La résistance de grille est choisie pour réaliser un compromis entre les pertes en commutation du transistor, l'amplitude du courant de conduction inverse de la diode de roue libre associée au transistor et les interférences électromagnétiques générées. Cependant, ce dispositif reste inadapté à la commande d'un transistor de type JFET. En effet, dans un JFET, l'intervalle de tension entre la tension minimale de mise en conduction et la tension maximale supportable par le transistor est très réduit. De cette manière, le transistor JFET requiert un dispositif de commande très précis dans lequel les performances en commutation doivent être optimisées. En optimisant les performances lors de la mise en conduction du transistor, il est ainsi possible de réduire les pertes en commutation ainsi que les interférences électromagnétiques.

Le but de l'invention est de proposer un dispositif de commande d'un transistor de type JFET ayant des performances optimisées en vue de réduire les pertes en commutation et les interférences électromagnétique lors de la mise en conduction du transistor.

Ce but est atteint par un dispositif de commande de grille d'un transistor de type JFET comportant une grille, un drain et une source, ledit dispositif étant **caractérisé en ce qu**'il comporte :

- un circuit de génération de tension comportant une sortie connectée à la grille du transistor, ledit circuit étant destiné à générer en sortie une tension grille-source de référence en suivant une rampe de tension prédéterminée,

- un circuit de limitation de tension destiné à limiter la tension grille-source de référence à une valeur maximale prédéterminée lorsque la tension grille-source aux bornes du transistor JFET a atteint ladite valeur maximale.

Selon une particularité de l'invention, le circuit de limitation comporte une entrée sur laquelle est appliquée la tension aux bornes d'un condensateur et une sortie sur laquelle est générée la tension grille-source de référence.

Selon une autre particularité, le circuit de limitation comporte un transistor bipolaire et des moyens de comparaison entre la tension grille-source du transistor JFET et la valeur maximale prédéterminée.

Selon une autre particularité, le circuit de limitation comporte une diode et en ce que la valeur maximale est déterminée par la somme de la tension seuil de conduction du transistor bipolaire et de la tension seuil de conduction de la diode.

Selon une autre particularité, le circuit de génération de tension comporte une résistance, une inductance et un condensateur reliés en série, formant un circuit RLC connecté entre la sortie d'un circuit d'entrée et la source du transistor JFET et une diode de clampage montée en parallèle du condensateur du circuit RLC entre une entrée du circuit de limitation et la source du transistor JFET.

Selon une autre particularité, le circuit de génération de tension comporte deux transistors bipolaires en série dont les deux bases sont reliées entre elles et connectées à la sortie du circuit de limitation.

Selon une autre particularité, le premier transistor bipolaire du circuit de génération de tension est de type PNP et le second transistor est de type NPN, les bornes émetteur des transistors étant connectées entre elles.

Selon une autre particularité, le dispositif de commande comporte un circuit d'entrée destiné à générer en sortie un signal de commande du transistor JFET.

Selon une autre particularité, le dispositif comporte une résistance de grille connectée entre la grille du transistor et la sortie du circuit de génération de tension.

Selon une autre particularité, le dispositif comporte une diode et un condensateur montés en série entre une première entrée du circuit de limitation et la masse et une diode de stabilisation montée en parallèle du condensateur.

2

L'invention concerne également un convertisseur de puissance comportant un étage onduleur comportant plusieurs transistors de type JFET, chaque transistor JFET étant commandé grâce à un dispositif de commande tel que défini ci-dessus.

L'invention peut s'appliquer à la commande d'un transistor JFET de type normalement ouvert ("normally OFF") ou de type normalement fermé ("normally ON").

Le dispositif de commande de l'invention permet de contrôler indépendamment la variation de courant en fonction du temps qui traverse le transistor et donc les interférences électromagnétiques générées par cette variation, ainsi que la variation de tension entre le drain et la source du transistor, et donc les pertes en commutation.

D'autres caractéristiques et avantages vont apparaître dans la description détaillée qui suit en se référant à un mode de réalisation donné à titre d'exemple et représenté par les dessins annexés sur lesquels :

- la figure 1 représente le dispositif de l'invention destiné à la commande d'un transistor de type JFET,

- la figure 2 montre l'évolution des différents paramètres intensité et tension dans le dispositif de commande représenté en figure 1,

- la figure 3 représente plus particulièrement le circuit de limitation de tension utilisé dans le dispositif de commande de l'invention,

- la figure 4 représente une variante de réalisation du dispositif de l'invention,

- la figure 5 montre les courbes d'évolution de la tension d'alimentation et du courant dans le dispositif représenté en figure 4.

Le dispositif de l'invention s'applique à la commande d'un transistor de type JFET (Junction Field Effect Transistor).

Un transistor JFET est un interrupteur électronique de puissance connu qui comporte une grille de commande (G) dont la fonction est d'autoriser ou non le passage d'un courant entre un drain (D) et une source (S). Un tel transistor est de type normalement fermé (ou "Normally ON") si la tension $V_{GS}$ entre la grille et la source est proche de zéro. Cela signifie que le chemin drain-source est passant ou conducteur en l'absence de tension de commande $V_{GS}$. Inversement un transistor JFET est de type normalement ouvert (ou "Normally OFF") si le chemin drain-source n'est pas conducteur en l'absence de tension $V_{GS}$ entre grille et source.

Selon l'invention, le transistor JFET commandé sera préférentiellement fabriqué dans un matériau à grande énergie de bande interdite ("Wide Gap Band Material"), par exemple en Carbure de Silicium ou Nitrure de Gallium, afin de présenter une faible résistance à l'état passant ($R_{DSon}$), donc de générer des pertes limitées, et de supporter des tensions importantes (supérieures à 600 V).

Un transistor JFET normalement fermé nécessite l'application d'une tension $V_{GS}$ entre grille et source qui soit négative pour être commandé à l'ouverture. Cette tension est typiquement comprise entre -5 Volts et -15 Volts.

Un transistor JFET normalement ouvert nécessite l'application d'une tension $V_{GS}$ entre grille et source qui soit positive pour être commandé à la fermeture. Cette tension positive est typiquement comprise entre +1 Volt et +3 Volts.

Les transistors JFETs peuvent être employés dans des applications de commutation allant de quelques kilohertz à quelques centaines de kilohertz, tels que des applications de type conversion de puissance tel que variation de vitesse, alimentation à découpage, ou alimentation sans interruption (UPS pour "Uninterruptible Power Supply").

Dans la suite de la description, le dispositif de l'invention est décrit pour la commande d'un transistor JFET de type normalement ouvert. Bien entendu, le dispositif de commande de l'invention est tout à fait adapté pour la commande d'un transistor JFET de type normalement fermé.

Le dispositif de commande de l'invention comporte notamment un circuit d'entrée 10, un circuit de génération de tension 11, un circuit de limitation de tension 12 et une résistance de grille $R_G$.

Le circuit d'entrée 10 est destiné à générer un signal de commande sur la grille du transistor JFET. Il comporte une diode D et deux interrupteurs S1, S2 en série. La sortie du circuit d'entrée 10 est connectée au point situé entre les deux interrupteurs. Le circuit d'entrée 10 est destiné à générer une tension d'entrée d'alimentation $V_{GG}$ pouvant prendre une valeur positive désignée $V_{CC}$, par exemple égale à +5V pour commander la mise en conduction du JFET et une valeur négative désignée $V_{EE}$, allant par de -15V à -20V, pour commander l'extinction du transistor JFET.

Le circuit de génération de tension 11 est connecté à la sortie du circuit d'entrée 10 et est destiné à générer une tension grille-source de référence $V_{REF}$, désignée ci-après tension de référence $V_{REF}$, selon une rampe de tension prédéterminée. La pente de la rampe de tension de référence $V_{REF}$ est approximativement constante.

Le circuit de génération de tension 11 comporte notamment un circuit RLC passif et une diode de clampage $D_Z$. La résistance R, l'inductance L et le condensateur C du circuit RLC sont connectées en série entre la sortie du circuit d'entrée 10 et la source S du transistor JFET commandé. La diode de clampage $D_Z$ est pour sa part connectée en parallèle du condensateur C du circuit RLC. Le point de connexion situé entre l'inductance L et le condensateur C est connecté à une première entrée (in1) du circuit de limitation de tension 12. Le circuit de génération de tension 11 comporte par ailleurs deux transistors Q1, Q2 bipolaires en série. Le transistor Q1 est de type NPN et a son collecteur (C) connecté à la tension positive Vcc. Le transistor Q2 est de type PNP dont l'émetteur (E) est connecté à l'émetteur (E) du transistor Q1 et le collecteur (C) est relié à la tension négative $V_{EE}$. Les bases (B) des deux transistors Q1, Q2 sont reliées entre elles, un point de connexion relié aux deux bases des transistors Q1, Q2 étant connecté à la sortie (out1) du circuit de limitation de tension 12.

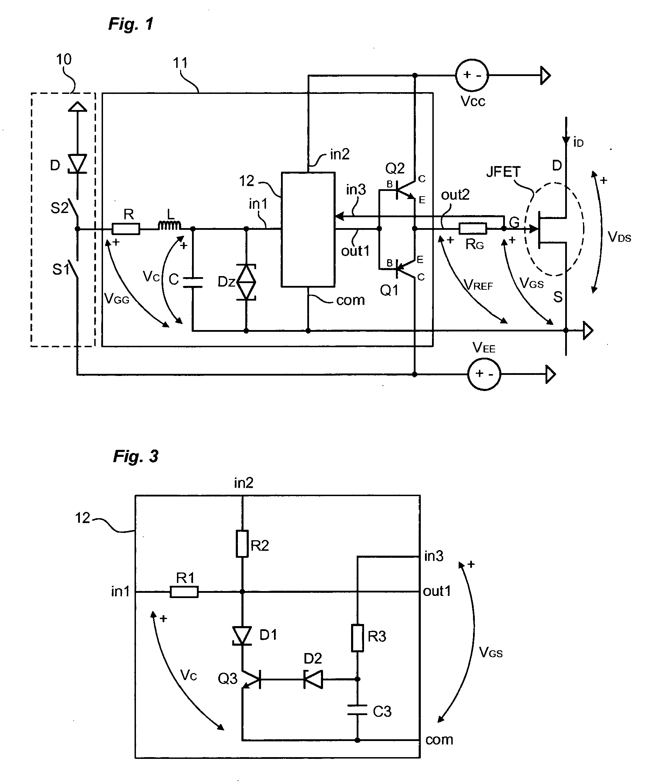

Le circuit de limitation de tension 12 représenté en figure 3 comporte pour sa part des résistances R1, R2, R3, des diodes D1 et D2, un condensateur C3 et un transistor Q3 bipolaire de type NPN. La première entrée (in1) du circuit de limitation de tension 12 est ainsi connectée directement à la sortie (out1) du circuit de limitation via la résistance R1. Une seconde entrée (in2) du circuit de limitation est reliée à la tension d'alimentation positive $V_{CC}$ et connectée à la sortie (out1) du circuit de limitation via la résistance R2. Le condensateur C3 et la résistance R3 sont connectés en série entre une troisième entrée (in3) et une borne de commun (com) du circuit de limitation 12. La troisième entrée (in3) du circuit de limitation 12 est connectée à la grille G du transistor JFET tandis que la borne de commun (com) est reliée à la source S du transistor JFET. La diode D1 est connectée entre la sortie (out1) du circuit de limitation 12 et le collecteur C du transistor Q3, tandis que l'émetteur du transistor Q3 est relié au commun (com). La diode D2 est pour sa part connectée entre la base du transistor Q3 et le point de connexion situé entre la résistance R3 et le condensateur C3 en série.

De cette manière, la tension $V_C$ aux bornes du condensateur C s'applique entre la première entrée (in1) du circuit de limitation 12 et la borne de commun (com) qui est connectée à la source S du JFET. Par ailleurs la tension grille-source $V_{GS}$ du transistor JFET s'applique entre la troisième entrée (in3) et la borne de commun (com) du circuit de limitation 12.

La sortie (out2) du circuit de génération de tension est connectée via la résistance de grille $R_G$ à la grille du transistor JFET commandé. La tension de référence $V_{REF}$ délivrée par le circuit de génération de tension 11 s'applique entre la sortie out2 du circuit de génération de tension 11 et la source S du transistor JFET.

Le principe de l'invention est d'optimiser la mise en conduction du transistor JFET. Afin d'accélérer la mise en conduction du transistor JFET, il est nécessaire de disposer d'un courant de grille $i_G$ suffisamment important. Cependant, les pertes en conduction et les interférences électromagnétiques doivent rester limitées.

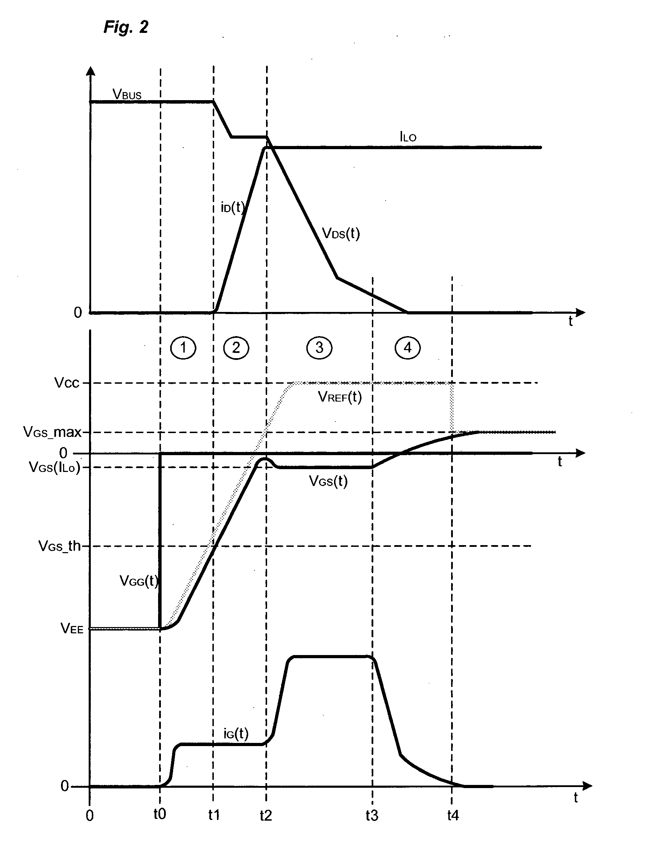

La séquence de mise en conduction peut se découper en quatre phases distinctes détaillées ci-dessous en référence à la figure 2 :

Phase 1

Un signal de fermeture du transistor JFET est envoyé au dispositif de commande entraînant la fermeture de l'interrupteur S2 et le chargement du circuit RLC via la diode D. Après la fermeture de l'interrupteur S2, la tension $V_C$ aux bornes du condensateur C augmente de la valeur négative d'alimentation $V_{EE}$ vers zéro. La tension de référence $V_{REF}$ augmente suivant la rampe prédéterminée de pente $dV_{REF}/dt$, entraînant également avec un léger retard, selon la même pente, l'augmentation de la tension grille-source $V_{GS}$ aux bornes du transistor JFET commandé. Durant cette première phase, la tension grille-source $V_{GS}$ est inférieure à la valeur seuil $V_{GS\_th}$ de mise en conduction du JFET. Par conséquent le courant de drain $i_D$ est nul.

Phase 2

La tension grille-source $V_{GS}$ atteint la valeur seuil $V_{GS\_th}$ de mise en conduction du JFET. Le courant de drain $i_D$ commence donc à traverser le JFET entre le drain D et la source S. Comme la tension grille-source $V_{GS}$ continue d'augmenter, le courant de drain $i_D$ augmente également selon la pente d'augmentation de la tension grille-source $V_{GS}$ et les caractéristiques du transistor JFET. Par conséquent, la variation du courant de drain $i_D$ est commandée par la variation de la tension grille-source $V_{GS}$ et donc par la tension de référence $V_{REF}$.

Phase 3

Le courant de drain $i_D$ atteint la valeur du courant de charge $i_{LO}$ et la tension drain-source $V_{DS}$ commence à diminuer. La diminution de la tension drain-source $V_{DS}$ est liée à l'augmentation importante du courant de grille $i_G$. Cette diminution de la tension drain-source $V_{DS}$ trouve son origine dans l'effet Miller du transistor JFET. Sur le plateau de Miller, comme le transistor est en région active, la tension grille-source $V_{GS}$ est constante ce qui entraîne le maintien à l'état constant du courant de drain $i_D$ à la valeur du courant de charge $I_{LO}$. Comme la tension de référence $V_{REF}$ continue d'augmenter pour atteindre la tension positive $V_{CC}$, le courant $i_G$ injecté sur la grille G du transistor JFET augmente également. En effet, la différence entre la tension de référence $V_{REF}$ et la tension grille-source $V_{GS}$ correspond à la tension $V_G$ aux bornes de la résistance de grille $R_G$. Ainsi plus la différence entre la tension de référence $V_{REF}$ et la tension grille-source $V_{GS}$ est importante, plus le courant injecté $i_G$ sur la grille G du transistor JFET est important. De plus, si la résistance de grille $R_G$ a une valeur particulièrement faible, le courant de grille $i_G$ augmente de manière significative. En considérant que la résistance de grille $R_G$ présente une valeur faible, par exemple de quelques Ohms, le courant de grille $i_G$ peut donc être fort et plus le courant de grille $i_G$ est fort, plus la décroissance de la tension drain-source $V_{DS}$ est rapide. Ainsi la dérive en tension est limitée et les pertes en commutation lors de la mise en conduction du transistor JFET sont réduites.

Phase 4

Une fois que la tension drain-source $V_{DS}$ approche zéro, la tension grille-source $V_{GS}$ poursuit son augmentation en suivant la progression de la tension de référence $V_{REF}$. Cependant, lorsque la tension grille-source $V_{GS}$ atteint la valeur maximale $V_{GS\_max}$, la tension grille-source $V_{GS}$ doit être limitée afin de ne pas détériorer le composant. Pour cela la tension de référence $V_{REF}$ est réduite à la valeur maximale $V_{GS\_max}$ de manière à plafonner la tension grille-source à la valeur maximale $V_{GS\_max}$.
L'énergie dissipée lors de la mise en conduction du transistor s'exprime par la relation suivante :

$$\text{Eon} \square \frac{1}{2}\left( \frac{V_{BUS} \square (I_{L0})^2}{di_D / dt} \square \frac{C_{DS} \square I_{L0} \square V_{BUS}^2}{i_G} \right) \square \frac{1}{2}\left( \frac{V_{BUS} \square (I_{L0})^2}{f_1(dVgs / dt)} \square \frac{C_{DS} \square I_{L0} \square V_{BUS}^2}{f_2(R_G)} \right)$$

A partir de cette formule, on constate que les pertes en commutation dépendent de la variation de la tension grille-source $V_{GS}$ au cours du temps et de l'amplitude du courant de grille $i_G$.
Lors de la phase de fonctionnement n°4, la tension de référence $V_{REF}$ est limitée à la valeur maximale $V_{GS\_max}$ grâce au circuit de limitation 12 représentée en figure 3. Lorsque la tension grille-source $V_{GS}$ qui s'applique entre la troisième entrée (in3) et la borne de commun (com) du circuit de limitation est inférieure à la somme de la tension seuil $V_{BE}$ de conduction du transistor Q3 et de la tension seuil $V_{D2}$ de conduction de la diode D2 du circuit de limitation 12, le transistor Q3 est alors bloqué et la tension $V_C$ aux bornes du condensateur C est transféré directement à la sortie (out1) du circuit de limitation 12. Lorsque la tension grille-source $V_{GS}$ devient supérieure à la somme des tensions seuil de conduction du transistor Q3 et de la diode D2, le transistor Q3 commence à conduire ce qui a pour effet de limiter la tension appliquée sur la sortie (out1) du circuit de limitation 12. Comme la tension appliquée sur la sortie (out1) est la tension de référence $V_{REF}$, la tension grille-source $V_{GS}$ sera automatiquement limitée. Comme $V_{GS\_max} \leq V_{BE} + V_{D2}$ et en considérant que la tension seuil $V_{BE}$ de conduction du transistor Q3 est de 0,7V et que la tension seuil $V_{D2}$ de conduction de la diode D2 est de 0,7V, la tension grille-source maximale $V_{GS\_max}$ vaut 1,4V. Dans le circuit de limitation 12 représenté en figure 3, la résistance R3 et le condensateur C3 forment un filtre passe-bas qui est employé pour filtrer le bruit à haute fréquence sur la tension grille-source $V_{GS}$ et permettent de limiter l'instabilité de la régulation sur la tension grille-source maximale $V_{GS\_max}$. La résistance R2 est employée comme une résistance de polarisation du transistor Q3 une fois que la commutation du transistor JFET est terminée.

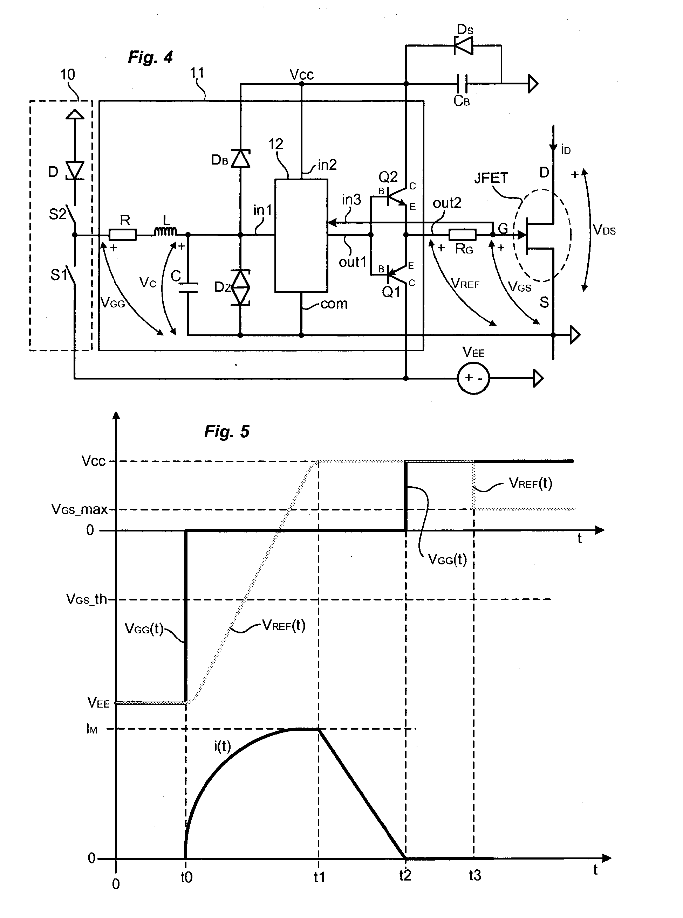

La figure 4 montre une variante de réalisation au dispositif de la figure 1. Comme mentionné précédemment, la tension grille-source $V_{GS}$ doit être légèrement positive pour commander la mise en conduction du transistor JFET. Pour cela, il est nécessaire de disposer d'une tension d'alimentation positive désignée ci-dessus $V_{CC}$. La variante de la figure 4 consiste à supprimer la partie positive de la tension d'alimentation et à générer cette tension d'alimentation positive directement dans le dispositif de commande ce qui permet de réduire la complexité du système d'alimentation du dispositif de commande. Pour cela le dispositif de commande comporte une diode $D_B$, appelé diode de renforcement ("boost diode"), un condensateur $C_B$, appelé condensateur de renforcement ("boost capacitor") et une diode $D_S$. La diode $D_B$ et le condensateur $C_B$ sont montés en série entre la première entrée in1 du circuit de limitation 12 et la masse. La diode $D_S$ est montée en parallèle du condensateur $C_B$.
En référence à la figure 5, à l'instant to, un signal de fermeture du transistor JFET est envoyé au dispositif de commande entraînant la fermeture de l'interrupteur S2 et l'apparition de la tension de commande de grille $V_{GG}$. Le condensateur C se charge de sorte que sa tension $V_C$ augmente de la tension d'alimentation négative $V_{EE}$ vers la tension d'alimentation positive $V_{CC}$ en passant par zéro. A l'instant t1, la tension aux bornes du condensateur C atteint la valeur $V_{CC}$ et la diode $D_B$ commence à conduire le courant. L'énergie alors emmagasinée dans l'inductance L, fonctiou du courant maximal $I_M$, peut alors être libérée dans le condensateur $C_B$. La quantité d'énergie libérée dans le condensateur $C_B$ est toujours identique quel que soit l'instant où le transistor JFET est mis en conduction. Cette énergie permet donc de couvrir la partie positive de l'alimentation du dispositif de commande et donc de maintenir une tension $V_{CC}$. La tension maximale est stabilisée grâce à la diode Zener $D_S$. A l'instant t2, le courant traversant l'inductance devient nul et reste à zéro car la diode D est bloquante. Le condensateur C reste chargé à la tension positive $V_{CC}$.

**Revendications**

1. Dispositif de commande de grille d'un transistor de type JFET comportant une grille, un drain et une source, ledit dispositif comportant :

   - un circuit de génération de tension (11) comportant une sortie (out2) connectée à la grille (G) du transistor, ledit circuit étant destiné à générer en sortie une tension grille-source de référence ($V_{REF}$) en suivant une rampe de tension prédéterminée,
   le circuit de génération de tension étant **caractérisé en ce qu'**il comporte :
   - un circuit de limitation de tension (12) comprenant un transistor bipolaire (Q3) et des moyens de comparaison entre la tension grille-source ($V_{GS}$) du transistor JFET et une valeur maximale ($V_{GS\_max}$) prédéterminée, ledit circuit de limitation étant destiné à limiter la tension grille-source de référence ($V_{REF}$) à ladite valeur maximale ($V_{GS\_max}$) prédéterminée lorsque la tension grille-source ($V_{GS}$) aux bornes du transistor JFET a atteint ladite valeur maximale.

2. Dispositif selon la revendication 1, **caractérisé en ce que** le circuit de limitation comporte une entrée (in1) sur laquelle est appliquée la tension aux bornes d'un condensateur (C) et une sortie destinée à générer la tension grille-source de référence ($V_{REF}$) .

3. Dispositif selon la revendication 1, **caractérisé en ce que** le circuit de limitation (12) comporte une diode (D2) et **en ce que** la valeur maximale est déterminée par la somme de la tension seuil ($V_{BE}$) de conduction du transistor bipolaire (Q3) et de la tension seuil ($V_{D2}$) de conduction de la diode (D2).

4. Dispositif selon l'une des revendications 1 à 3, **caractérisé en ce que** le circuit de génération de tension (11) comporte une résistance (R), une inductance (L) et un condensateur (C) reliés en série, formant un circuit RLC connecté entre la sortie d'un circuit d'entrée (10) et la source du transistor JFET et une diode de clampage ($D_Z$) montée en parallèle du condensateur (C) du circuit RLC entre une entrée (in1) du circuit de limitation (12) et la source du transistor JFET.

5. Dispositif selon la revendication 4, **caractérisé en ce que** le circuit de génération de tension (11) comporte deux transistors bipolaires (Q1, Q2) en série dont les deux bases sont reliées entre elles et connectées à la sortie (out1) du circuit de limitation (12).

6. Dispositif selon la revendication 5, **caractérisé en ce que** le premier transistor bipolaire (Q1) est de type PNP et le second transistor (Q2) est de type NPN, les bornes émetteur des transistors étant connectées entre elles.

7. Dispositif selon la revendication 1, **caractérisé en ce qu'**il comporte un circuit d'entrée (10) destiné à générer en sortie un signal de commande du transistor JFET.

8. Dispositif selon l'une des revendications 1 à 7, **caractérisé en ce qu'**il comporte une résistance de grille ($R_G$) connectée entre la grille (G) du transistor et la sortie (out2) du circuit de génération de tension (11).

9. Dispositif selon la revendication 1, **caractérisé en ce qu'**il comporte une diode ($D_B$) et un condensateur ($C_B$) montés en série entre une première entrée (in1) du circuit de limitation (12) et la masse et une diode de stabilisation montée en parallèle du condensateur ($C_B$).

10. Convertisseur de puissance comprenant un étage onduleur comportant plusieurs transistors de type JFET, **caractérisé en ce que** chaque transistor JFET est commandé grâce à un dispositif de commande tel que défini dans l'une des revendications précédentes.

**Patentansprüche**

1. Gate-Steuervorrichtung eines Transistors von der Art Sperrschicht-FET, der ein Gate, einen Drain und eine Source aufweist, wobei die Vorrichtung aufweist:

- eine Spannungserzeugungsschaltung (11), die einen mit dem Gate (G) des Transistors verbundenen Ausgang (out2) aufweist, wobei die Schaltung dazu bestimmt ist, am Ausgang eine Gate-Source-Bezugsspannung ($V_{REF}$) gemäß einer vorbestimmten Spannungsrampe zu erzeugen,
wobei die Spannungserzeugungsschaltung **dadurch gekennzeichnet ist, dass** sie aufweist:
- eine Spannungsbegrenzungsschaltung (12), die einen bipolaren Transistor (Q3) und Vergleichseinrichtungen zwischen der Gate-Source-Spannung ($V_{GS}$) des Sperrschicht-FETs und einem vorbestimmten Maximalwert ($V_{GS\_max}$) enthält, wobei die Begrenzungsschaltung dazu bestimmt ist, die Gate-Source-Bezugsspannung ($V_{REF}$) auf den vorbestimmten Maximalwert ($V_{GS-max}$) zu begrenzen, wenn die Gate-Source-Spannung ($V_{GS}$) an den Klemmen des Sperrschicht-FETS den Maximalwert erreicht hat.

2. Vorrichtung nach Anspruch 1, **dadurch gekennzeichnet, dass** die Begrenzungsschaltung einen Eingang (in1), an den die Spannung an den Klemmen eines Kondensators (C) angelegt wird, und einen Ausgang aufweist, der dazu bestimmt ist, die Gate-Source-Bezugsspannung ($V_{REF}$) zu erzeugen.

3. Vorrichtung nach Anspruch 1, **dadurch gekennzeichnet, dass** die Begrenzungsschaltung (12) eine Diode (D2) aufweist, und dass der Maximalwert durch die Summe der Leitungsschwellenspannung ($V_{BE}$) des bipolaren Transistors (Q3) und der Leitungsschwellenspannung ($V_{D2}$) der Diode (D2) bestimmt wird.

4. Vorrichtung nach einem der Ansprüche 1 bis 3, **dadurch gekennzeichnet, dass** die Spannungserzeugungsschaltung (11) einen Widerstand (R), eine Induktivität (L) und einen Kondensator (C) in Reihe geschaltet, die eine RLC-Schaltung formen, die zwischen dem Ausgang einer Eingangsschaltung (10) und der Source des Sperrschicht-FETs verbunden ist, und eine Klemmdiode (Dz) aufweist, die mit dem Kondensator (C) der RLC-Schaltung zwischen einem Eingang (in1) der Begrenzungsschaltung (12) und der Source des Sperrschicht-FETs parallel geschaltet ist.

5. Vorrichtung nach Anspruch 4, **dadurch gekennzeichnet, dass** die Spannungserzeugungsschaltung (11) zwei in Reihe geschaltete bipolare Transistoren (Q1, Q2) aufweist, deren zwei Basen miteinander verbunden und an den Ausgang (out1) der Begrenzungsschaltung (12) angeschlossen sind.

6. Vorrichtung nach Anspruch 5, **dadurch gekennzeichnet, dass** der erste bipolare Transistor (Q1) vom PNP-Typ und der zweite Transistor (Q2) vom NPN-Typ ist, wobei die Emitterklemmen der Transistoren miteinander verbunden sind.

7. Vorrichtung nach Anspruch 1, **dadurch gekennzeichnet, dass** sie eine Eingangsschaltung (10) aufweist, die dazu bestimmt ist, am Ausgang ein Steuersignal des Sperrschicht-FETs zu erzeugen.

8. Vorrichtung nach einem der Ansprüche 1 bis 7, **dadurch gekennzeichnet, dass** sie einen Gate-Widerstand ($R_G$) aufweist, der zwischen dem Gate (G) des Transistors und dem Ausgang (out2) der Spannungserzeugungsschaltung (11) angeschlossen ist.

9. Vorrichtung nach Anspruch 1, **dadurch gekennzeichnet, dass** sie eine Diode ($D_B$) und einen Kondensator ($C_B$), die zwischen einem ersten Eingang (in1) du Begrenzungsschaltung (12) und Masse in Reihe geschaltet sind, und eine Stabilisierungsdiode aufweist, die mit dem Kondensator ($C_B$) parallel geschaltet ist.

10. Leistungswandler, der eine Wechselrichterstufe enthält, die mehrere Transistoren von der Art Sperrschicht-FET aufweist, **dadurch gekennzeichnet, dass** jeder Sperrschicht-FET mit Hilfe einer Steuervorrichtung gesteuert wird, wie sie in einem der vorhergehenden Ansprüche definiert ist.

**Claims**

1. Gate control device for a JFET-type transistor comprising a gate, a drain and a source, said device comprising:

- a voltage generation circuit (11) comprising an output (out2) connected to the gate (G) of the transistor, said circuit being designed to generate at the output a reference gate-source voltage ($V_{REF}$) following a predetermined voltage ramp,
the voltage generation circuit being **characterized in that** it comprises:

- a voltage limiting circuit (12) comprising a bipolar transistor (Q3) and comparison means between the gate-source voltage ($V_{GS}$) of the JFET transistor and a predetermined maximum value ($V_{GS\_max}$), said limiting circuit being designed to limit the reference gate-source voltage ($V_{REF}$) to said predetermined maximum value ($V_{GS\_max}$) when the gate-source voltage ($V_{GS}$) at the terminals of the JFET transistor has reached said maximum value.

2. Device according to Claim 1, **characterized in that** the limiting circuit comprises an input (in1) to which is applied the voltage at the terminals of a capacitor (C) and an output designed to generate the reference gate-source voltage ($V_{REF}$).

3. Device according to Claim 1, **characterized in that** the limiting circuit (12) comprises a diode (D2) and **in that** the maximum value is determined by the sum of the conduction threshold voltage ($V_{BE}$) of the bipolar transistor (Q3) and the conduction threshold voltage ($V_{D2}$) of the diode (D2).

4. Device according to one of Claims 1 to 3, **characterized in that** the voltage generation circuit (11) comprises a resistor (R), an inductor (L) and a capacitor (C) connected in series, forming an RLC circuit connected between the output of an input circuit (10) and the source of the JFET transistor and a clamping diode ($D_Z$) connected in parallel with the capacitor (C) of the RLC circuit between an input (in1) of the limiting circuit (12) and the source of the JFET transistor.

5. Device according to Claim 4, **characterized in that** the voltage generation circuit (11) comprises two bipolar transistors (Q1, Q2) in series, the two bases of which are connected together and connected to the output (out1) of the limiting circuit (12).

6. Device according to Claim 5, **characterized in that** the first bipolar transistor (Q1) is of PNP type and the second transistor (Q2) is of NPN type, the emitter terminals of the transistors being connected together.

7. Device according to Claim 1, **characterized in that** it comprises an input circuit (10) designed to generate at the output a control signal for the JFET transistor.

8. Device according to one of Claims 1 to 7, **characterized in that** it comprises a gate resistor ($R_G$) connected between the gate (G) of the transistor and the output (out2) of the voltage generation circuit (11).

9. Device according to Claim 1, **characterized in that** it comprises a diode ($D_B$) and a capacitor ($C_B$) connected in series between a first input (in1) of the limiting circuit (12) and the ground and a stabilization diode connected in parallel with the capacitor ($C_B$).

10. Power converter with an inverter stage comprising a number of JFET-type transistors, **characterized in that** each JFET transistor is controlled by virtue of a control device as defined in one of the preceding claims.

**Fig. 1**

**Fig. 3**

*Fig. 2*

**Fig. 4**

**Fig. 5**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **PETAR J. GRBOVIC.** An IGBT Gate Driver for Feed-Forward control Turnon Losses and Reverse Recovery Current. *IEEE Transactions on Power Electronics,* Mars 2008, vol. 23 (2), 643